Europäisches Patentamt

European Patent Office

Office européen des brevets

(19)

(11) Veröffentlichungsnummer: **0 482 240 A1**

(12) **EUROPÄISCHE PATENTANMELDUNG**

(21) Anmeldenummer: **90120422.2**

(22) Anmeldetag: **24.10.90**

(51) Int. Cl.⁵: **H01L 31/18**

(43) Veröffentlichungstag der Anmeldung:
**29.04.92 Patentblatt 92/18**

(84) Benannte Vertragsstaaten:
**AT BE CH DE DK ES FR GB GR IT LI LU NL SE**

(71) Anmelder: **Siemens Solar GmbH**
**Frankfurter Ring 152**
**W-8000 München 46(DE)**

(72) Erfinder: **Goslowsky, Hans, Dr. Dipl.-Phys.**
**Joh.-Baptist-Zimmermannstrasse 5**
**W-8018 Grafing(DE)**
Erfinder: **Schulze, Friedrich, Dr. Dipl.-Chem.**
**Am Lochfeld 12**
**W-8088 Eching(DE)**

(74) Vertreter: **Fuchs, Franz-Josef, Dr.-Ing.**
**Postfach 22 13 17**
**W-8000 München 22(DE)**

(54) Verfahren zur massgenauen Bearbeitung von flachen und/oder leicht gewölbten Werkstücken.

(57) Es wird ein Verfahren zur Bearbeitung eines flachen und/oder leicht gewölbten Werkstücks 1 vorgeschlagen, bei dem ein Werkzeug (8, 10, 11) mit hoher Genauigkeit äquidistant zu einer vorgegebenen Marke 4 auf dem Werkstück geführt wird. Die Marke wird optisch von einem Detektionselement 6 erfaßt, dessen Signal über einen einfachen Regelkreis ein gegebenenfalls notwendiges Nachführen des Werkzeugs regelt. Bei verringertem apparativen Aufwand der Werkzeugführung in Bearbeitungsrichtung wird eine hohe Bearbeitungsgenauigkeit erzielt.

Die Erfindung betrifft ein Bearbeitungsverfahren für flache und/oder leicht gewölbte Werkstücke, insbesondere für flächige Werkstücke mit Ausdehnungen im 1 m Bereich, welche eine hohe Präzision erfordern.

Unter Bearbeitung eines Werkstücks werden alle die Behandlungen mit einem Werkzeug verstanden, die in einem schmalen oder eng begrenzten Bereich des Werkstückes vorgenommen werden. Solche eng begrenzten Bereiche können bei einer Werkstofflänge von ca. 1 m Bearbeitungstoleranzen von ca. 10 μm oder weniger erfordern.

Ein Verfahren, bei dem ein flächiges Werkstück mit einer hohen Präzision von ± 10 μm bearbeitet werden muß, ist die Strukturierung von großflächigen Dünnschichtsolarzellen in sogenannten Solarmodulen. Ein solches, welches beispielsweise eine Fläche von 1300 x 340 mm² aufweist, wird bei der Strukturierung zum Beispiel in streifenförmige Einzelzellen unterteilt, wobei wegen der nachfolgenden Serienverschaltung eine hohe Präzision dieser Schnitte relativ zu bereits durchgeführten Verfahrensschritten eingehalten werden muß. Eine solche Vorgehensweise erfordert präzise Verstellelemente, eine exakte Werkzeugführung und einen Wegaufnehmer. Die präzisen Verstellelemente und deren Steuerung sind aufwendig und kostenintensiv. Außerdem ist beim Verfahren selbst die Ausrichtung von Solarzellenkörper und Werkzeug zeitaufwendig und stellt eine potentielle Fehlerquelle durch Bedienungsfehler dar. Eine Automatisierung der Ausrichtung, zum Beispiel durch Bildverarbeitung, erhöht die Komplexität der Anlage. Beschaffungs- und Instandhaltungskosten würden so erhöht. Außerdem muß jedes Solarmodul einzeln bearbeitet werden.

Aufgabe der vorliegenden Erfindung ist es daher, ein einfaches Verfahren zur Bearbeitung solcher Werkstücke anzugeben, welches mit einem geringen Vorrichtungsaufwand auskommt und außerdem eine präzise Bearbeitung mit hoher Genauigkeit ermöglicht.

Diese Aufgabe wird erfindungsgemäß gelöst durch ein Verfahren zur maßgenauen Bearbeitung eines flachen und/oder leicht gewölbten Werkstücks, welches die Schritte aufweist

a) grobes Positionieren und Fixieren des Werkstücks bezüglich einer Bearbeitungsrichtung auf einem Bearbeitungstisch,

b) Ausrichten eines Detektionselements, bis eine auf dem Werkstück befindliche Marke im Detektionsbereich des Detektionselements zu liegen kommt,

c) Ausrichten eines Werkzeugs auf einen gewünschten Startpunkt auf dem Werkstück relativ zur Marke,

d) Start der Bearbeitung des Werkstücks durch das Werkzeug,

e) Durchführen einer Relativbewegung von Werkzeug zu Werkstück in Bearbeitungsrichtung,

f) Erzeugen eines Detektionssignals durch das Detektionselement, Vergleichen des Signals mit einem Sollwert und gegebenenfalls Erzeugen eines Korrektursignals in einem Regelkreis und

g) Nachführen des Werkzeugs mit einer Nachführeinrichtung gemäß dem Korrektursignal, bis das Detektionssignal mit dem Sollwert übereinstimmt.

Weitere Ausgestaltungen der Erfindung sind den Unteransprüchen zu entnehmen.

Die Erfindung stellt ein einfaches und apparativ wenig aufwendiges Verfahren zur Bearbeitung eines Werkstücks dar, welches mit einem geringen Aufwand einen automatischen Fehlerausgleich ermöglicht und so eine präzise Bearbeitung mit geringer Fehlertoleranz erlaubt. Dabei kann die Durchführung der zum Beispiel vorprogrammierten Relativbewegung zwischen Werkzeug und Werkstück relativ ungenau sein und zum Beispiel eine um dem Faktor 100 höhere Abweichung gegenüber der geforderten Toleranz aufweisen. Der Präzisionsschritt des Verfahrens besteht dabei in der Nachführung des Werkzeugs gemäß dem Korrektursignal, welche nur in einem relativ schmalen Bereich (im Vergleich zur zu bearbeitenden Weglänge auf dem Werkstück) erfolgen muß und daher nur eines geringen apparativen mechanischen Aufwands bedarf. Auch die Grobjustierung des Werkstücks auf der Werkbank ist einfach durchzuführen, hat als Fehlertoleranz den Detektionsbereich des Detektionselementes und ist daher von dessen Ausführung abhängig. Die Grobjustierung kann auch durch einen mechanischen Suchlauf erfolgen, bei dem die Detektionsmarke in den Detektionsbereich des Detektionselementes geführt wird. Im Normalfall übertrifft er die durch die Relativbewegung zu erwartende Fehlerabweichung um zumindest eine Größenordnung.

Die der Grobjustierung folgende Feinjustierung, das heißt das Ausrichten des Werkzeugs auf den gewünschten Startpunkt, kann automatisiert durch Vorgabe eines gewünschten Wertes folgen, da das Werkzeug in einem vorgegebenen Abstand zum Detektionselement bzw. zum Sollwert der Lage der Marke eingerichtet wird.

Weiterhin ist es möglich, mit dem erfindungsgemäßen Verfahren mehrere Werkstücke in einem Arbeitsgang zu bearbeiten, wobei die Zahl der Werkstücke von der Anzahl der vorhandenen Werkzeuge abhängig ist. Jedem Werkzeug wird ein Detektionselement zugeordnet. Wesentlich ist jedoch, daß nur eine Relativbewegung in Bearbeitungsrichtung für alle Werkstücke durchgeführt werden muß. Mehrere Detektionselemente erlauben auch bei unterschiedlicher Justierung der einzelnen Werkstücke zueinander den automatischen Fehlerausgleich mit der gleichen Präzision wie bei der Bearbeitung eines einzelnen Werkstückes.

Ein geeigneter Bearbeitungstisch für das erfindungsgemäße Verfahren weist ein mechanisches Verstellelement zur Durchführung der Relativbewegung auf. Zur Grobjustierung der Werkstücke auf dem Bearbeitungstisch sind Anschläge geeignet, die auch zur Fixierung des Werkstückes dienen können. Die Relativbewegung ist im einfachsten Fall eine Linearbewegung, die sich zum Beispiel mit einem Linearschlitten durchführen läßt. Detektionselement und Werkzeug sind so an der Werkbank befestigt, daß sich ein beliebiger Abstand zwischen Marke und Werkzeug einstellen läßt. Dazu ist entweder das Detektionselement, das Werkzeug oder beide verstellbar befestigt.

Die Art der Bearbeitung, die mit dem erfindungsgemäßen Verfahren durchgeführt werden kann, ist nahezu beliebig. Üblich sind jedoch Verfahren zum Materialabtrag- oder -auftrag, zur Verformung eines Werkstücks oder eine Kombination verschiedener Bearbeitungsverfahren. Diese sind wiederum von der Art des Werkstückes abhängig, welches ein flacher oder gewölbter Körper ist, so daß dessen Bearbeitung bzw. die Führung des Werkzeugs im wesentlichen ein zweidimensionales Problem ist.

Besonders vorteilhaft läßt sich das Verfahren zur Strukturierung von großflächigen Dünnschichtsolarzellen zu Solarmodulen einsetzen. Dabei wird eine großflächige Halbleiterschicht, bzw. eine daraus gefertigte großflächige Solarzelle (beispielsweise mit einer Abmessung von 1300 x 340 mm$^2$) in kleinere Einzelsolarzellen unterteilt und schließlich serienverschaltet. Dazu nötige Bearbeitungsschritte sind zum Beispiel Abtrag von Halbleitermaterial zwischen zwei gewünschten Einzelsolarzellen zur Herausbildung der Einzelsolarzellen oder verschiedene Verfahren zur Unterteilung von üblicherweise ebenfalls ganzflächig aufgebrachten Elektrodenschichten in Einzelelektroden bzw. in die Elektrodenflächen von Einzelsolarzellen. Der Materialabtrag zur Erzeugung schmaler Gräben kann durch Schneiden oder Fräsen erfolgen, wird aber vorteilhafterweise wegen der einfachen Führung und der exakt möglichen Fokussierung mit einem Laser durchgeführt.

Die Marke, die die Bearbeitungsrichtung und somit die Führung des Werkzeugs vorgibt, kann eine natürliche Markierung auf dem Werkstück sein, beispielsweise eine Kante desselben. Bei der Durchführung mehrerer Verfahrens- bzw. Bearbeitungsschritte wird vorteilhafterweise die Spur des Werkzeugs aus einem vorhergehenden Bearbeitungsschritt als Marke gewählt. Dies hat zudem den Vorteil, daß die verschiedenen Bearbeitungsschritte exakt zueinander ausgerichtet werden können. Es ist aber auch möglich, eine durch einen vorherigen Prozeßschritt aufgebrachte Markierung auf dem Werkstück zur Werkzeugführung zu benützen.

Das Detektionselement zum Erkennen der Marke ist üblicherweise eine optische Einrichtung, beispielsweise eine Positionierdiode, eine Zeilen- oder eine CCD-Kamera. Die Marke ist so gestaltet, daß sie von dem Detektionselement sicher erkannt wird und daß dazu keine komplexen Auswertungsverfahren erforderlich sind. Gleichzeitig liefert das Detektionselement ein Detektionssignal, welches eine Ortsinformation über die Marke enthält. Da sowohl die Marke wie auch der entsprechende Bearbeitungsschritt kontinuierlich und üblicherweise linear ablaufen, ist nur eine eindimensionale Ortsinformation erforderlich. Diese kann in einem einfachen Regelkreis mit einem Sollwert verglichen werden, wobei bei einer etwaigen Abweichung ein Korrektursignal erzeugt wird. Mit diesem wird das Werkzeug über die Nachführeinrichtung in der relativen Lage zur Marke korrigiert, bis die exakte Positionierung gegenüber der Marke erreicht ist. Die Genauigkeit, mit der diese Nachführung erfolgt, bestimmt die Genauigkeit des Bearbeitungsschrittes, sofern nicht die Ortsauflösung des Detektionselements der begrenzende Faktor ist.

Im folgenden wird die Erfindung anhand eines Ausführungsbeispiels und der Figur näher erläutert.

Die Figur zeigt in schematischer Darstellung die Strukturierung einer Dünnschichthalbleiterzelle mit dem erfindungsgemäßen Verfahren mit Hilfe eines Lasers.

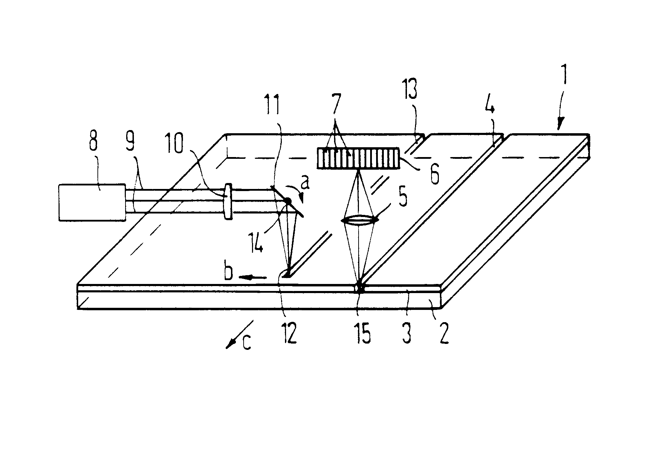

Ausführungsbeispiel (siehe Figur 1)

Eine großflächige Dünnschichtsolarzelle 1, beispielsweise aus amorphem Silizium, soll in mehrere streifenförmige Einzelsolarzellen unterteilt und diese anschließend zu einem Modul verschaltet werden. Im Ausführungsbeispiel ist dazu ein Substrat 2 mit einer streifenförmig strukturierten Elektrodenschicht (nicht dargestellt) versehen, auf der eine aktive Halbleiterschicht 3 aus amorphem Silizium abgeschieden wurde. In einem vorherigen Verfahrensschritt wurde ein schmaler Graben 4 in der Solarzelle 1 erzeugt, in dem die Halbleiterschicht vollständig mit einem Werkzeug (Laser) abgetragen wurde. Im dargestellten Verfahrensschritt wird nun in genau bestimmter Lage relativ zum ersten Graben 4 ein zweiter Graben 13 erzeugt. Dazu wird ein bestimmter Bereich der Oberfläche (Detektionsbereich) quer zum Graben 4 von einem Detektionselement 6 beobachtet. Das von einer Abbildungsoptik 5 auf dem Detektionselement 6 fokussierte Abbild des Detektionsbereichs wird von einer Reihe nebeneinander angeordneter einzelner lichtempfindlicher Elemente 7 in ein entsprechendes elektrisches Detektionssignal umgewandelt. Dieses enthält eine Ortsangabe des im Graben 4 gelegenen beobachteten Punktes 15 und wird in einem einfachen Regelkreis (nicht dargestellt) mit einem Sollwert verglichen. Entsprechend der Abweichung vom Sollwert wird ein Korrektursignal erzeugt, mit welchem das Werkzeug gesteuert wird. Dieses besteht aus einem Laser 8, dessen Lichtstrahl 9 über eine Sammellinse 10 und einen Ablenkspiegel 11 auf dem Halbleitermaterial der Solarzelle 1 im Punkt 12 fokussiert wird. Mit dem Korrektursignal wird eine Drehung des Ablenkspiegels 11 um dessen Achse 14 gesteuert. Eine Drehung des Ablenkspiegels 11 um die Achse 14 in Drehrichtung a bewirkt daher, daß der im Punkt 12 fokussierte Laserstrahl 9 in Richtung b auf der Oberfläche verschoben wird. Der Ablenkspiegel 11 stellt daher die Nachführeinrichtung des Werkzeuges 8 dar, mit dem eine genaue Lage des in Bearbeitungsrichtung c weiter zu erzeugenden Grabens 13 relativ zur Marke 4 eingehalten wird. Laser 8 und Detektionselement 6 sind samt der dazugehörigen Optik 5 bzw. 10 in einer festen Lage zueinander fixiert, während das einzig bewegliche Element 11 mit einer präzisen Mechanik ausgestattet ist. Durch die unabhängig davon erfolgende Relativbewegung zwischen Solarzelle 1 und den dargestellten optischen Einrichtungen samt Werkzeug 8 wird der Fokus 12 des Laserstrahls 9 in Bearbeitungsrichtung c über die Oberfläche der Solarzelle 1 geführt. Das im Vergleich zur Relativbewegung und damit zur Bearbeitungsgeschwindigkeit schnelle Nachführen des Ablenkspiegels 11 gemäß dem Korrektursignal ermöglicht eine exakt parallele Ausrichtung des Grabens 13 zum Graben 4 (Marke). In nachfolgenden Bearbeitungsschritten können weitere Gräben in paralleler Ausrichtung zum Graben 4 oder 13 erzeugt werden. Dies ist auch dann möglich, wenn die Richtung der Relativbewegung nicht exakt mit der gewünschten Bearbeitungsrichtung c übereinstimmt. Erforderlich ist nur, daß in der Relativbewegung keine Diskontinuitäten auftreten und eine ausreichende Wiederholgenauigkeit eingehalten wird. Selbst bei Abweichungen bis 0,5 mm werden durch einen exakt arbeitenden Ablenkspiegel 11 (Scanner) exakt positionierte Gräben 13 erzeugt, deren Abweichung von der gewünschten Marke maximal 10 $\mu$m beträgt.

**Patentansprüche**

1. Verfahren zur maßgenauen Bearbeitung eines flachen und/oder leicht gewölbten Werkstücks mit den Schritten

a) grobes Positionieren und Fixieren des Werkstücks (1) bezüglich einer Bearbeitungsrichtung auf einem Bearbeitungstisch,

b) Ausrichten eines Detektionselements (6), bis eine auf dem Werkstück (1) befindliche Marke (4) im Detektionsbereich des Detektionselements zu liegen kommt,

c) Ausrichten eines Werkzeugs (8, 10, 11) auf einen gewünschten Startpunkt auf dem Werkstück (1) relativ zur Marke (4),

d) Start der Bearbeitung des Werkstücks durch das Werkzeug,

e) Durchführen einer Relativbewegung von Werkzeug zu Werkstück in Bearbeitungsrichtung,

f) Erzeugen eines Detektionssignals durch das Detektionselement (6), Vergleichen des Signals mit einem Sollwert und gegebenenfalls Erzeugen eines Korrektursignals in einem Regelkreis,

g) Nachführen des Werkzeugs mit einer Nachführeinrichtung (11) gemäß dem Korrektursignal, bis das Detektionssignal mit dem Sollwert übereinstimmt.

2. Verfahren nach Anspruch 1, **dadurch gekennzeichnet,** daß die Verfahrensschritte b) bis g) mit der Maßgabe wiederholt werden, daß die mit dem Werkzeug durch die vorherige Bearbeitung des Werkstücks erzeugte Spur als Marke für das Detektionselement herangezogen wird.

3. Verfahren nach Anspruch 1 oder 2, **dadurch gekennzeichnet,** daß mehrere Körper auf dem Bearbeitungstisch angeordnet werden, daß weiterhin eine der Anzahl der Werkstücke entsprechende Anzahl Werkzeuge vorhanden ist und daß die in einer bestimmten Lage zueinander fixierten Werkstücke durch die eine Relativbewegung gleichzeitig einer Bearbeitung durch die Werkzeuge unterzogen werden.

4. Verfahren nach einem der Ansprüche 1 bis 3, **dadurch gekennzeichnet,** daß als Detektionselement eine Zeilenkamera verwendet wird.

5. Verfahren nach einem der Ansprüche 1 bis 3, **dadurch gekennzeichnet**, daß als Detektionselement eine CCD-Kamera verwendet wird.

6. Verfahren nach einem der Ansprüche 1 bis 3, **dadurch gekennzeichnet,** daß als Detektionselement eine Positionierdiode verwendet wird.

7. Verfahren nach einem der Ansprüche 1 bis 6, **dadurch gekennzeichnet,** daß als Werkstükke großflächige Dünnschichtsolarzellen bearbeitet werden.

8. Verfahren nach Anspruch 7, **dadurch gekennzeichnet,** daß durch die Bearbeitung die Solarzellen zu einem Modul strukturiert werden.

9. Verfahren nach einem der Ansprüche 1 bis 8, **dadurch gekennzeichnet,** daß mit dem Werkzeug ein Schnitt erzeugt wird.

10. Verfahren nach Anspruch 9, **dadurch gekennzeichnet,** daß das Werkzeug ein Laser ist.

11. Verfahren nach Anspruch 10, **dadurch gekennzeichnet,** daß der Laser mit einem beweglichen Ablenkspiegel gemäß dem Korrektursignal nachgeführt wird.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | US-A-4 689 874   (M. NISHIURA) <br> * Abbildungen; Spalte 4, Zeile 2 - Spalte 6, Zeile 13; Patentansprüche * <br> — — — | 1,2,4,5, 7-10 | H 01 L 31/18 <br> H 01 L 31/20 |
| A | JAPANESE JOURNAL OF APPLIED PHYSICS, Band 25, Nr. 12, Dezember 1986, Seiten 1936-1943, Tokyo, JP; S. NAKA-NO et al.: Laser patterning method for integrated type a-Si solar cell submodules" <br> * Das ganze Dokument * <br> — — — | 1,4,5, 7-11 | |
| A | SOLAR CELLS, Band 29, Nr. 4, Oktober 1990, Seiten 361-368, Lausanne, CH; T. MATSUOKA et al.: "A new solar cell roofing tile" <br> * Seiten 362-364 * <br> — — — | 1,5,7-10 | |
| A | FR-A-2 550 007   (SANYO ELECTRIC CO., LTD) <br> — — — | | |
| A | THE CONFERENCE RECORD OF THE 17TH IEEE PHOTO-VOLTAIC SPECIALISTS CONFERENCE, Kissimmee, Florida, 1. - 4. Mai 1984, Seiten 206-211; S. YAMAZAKI et al.: "Mask-less fabrication of a-Si solar cell using laser scribe process" <br> — — — — — | | |

**RECHERCHIERTE SACHGEBIETE (Int. Cl.5)**

H 01 L

Der vorliegende Recherchenbericht wurde für alle Patentansprüche erstellt

| Recherchenort | Abschlußdatum der Recherche | Prüfer |
|---|---|---|
| Den Haag | 28 Juni 91 | VISENTIN A. |